# EUROPEAN PATENT SPECIFICATION

(11) **EP 2 034 481 B1**
(45) Date of publication and mention of the grant of the patent: **09.04.2014**
(21) Application number: 07708018.2
(22) Date of filing: 05.02.2007
(51) Int. Cl.: G11B 27/00, G11B 27/34, G11B 20/10, G11B 27/10, G11B 27/36, G10H 1/00, H03M 7/30, H04N 5/85, H04N 5/937

(54) **REPRODUCTION DEVICE, REPRODUCTION METHOD, PROGRAM, AND STORAGE MEDIUM**
WIEDERGABEEINRICHTUNG, WIEDERGABEVERFAHREN, PROGRAMM UND SPEICHERMEDIUM
DISPOSITIF ET PROCÉDÉ DE LECTURE, PROGRAMME ET SUPPORT DE STOCKAGE

(30) Priority: 16.06.2006 JP 2006167578
(43) Date of publication of application: 11.03.2009
(73) Proprietor: D&M Holdings, Inc., Kanagawa 210-8569 (JP)
(72) Inventor: ENDO, Yasuhiro, Kawasaki-shi, Kanagawa 210-8569 (JP); ONIZUKA, Kazuhiro, Kawasaki-shi, Kanagawa 210-8569 (JP)
(74) Representative: Hackney, Nigel John
(86) International application number: PCT/JP2007/051899
(87) International publication number: WO 2007/144994

(56) References cited:
- EP-A1- 1 533 809
- EP-A2- 1 119 194
- EP-A2- 1 519 386
- GB-A- 2 356 733
- JP-A- 2001 175 253
- JP-A- 2005 108 294
- US-A1- 2005 185 923

## Description

### Technical Field

The present invention relates to a technique on a reproduction apparatus that can asynchronously reproduce an audio signal and a video signal recorded synchronously with each other.

### Background Art

As digital techniques develop, it becomes common to use a CD player that can perform special reproduction of a Compact Disc (CD) in a similar way to special reproduction using an analog record (such as so-called scratch reproduction). Such a CD player is used favorably by a Disc Jockey (DJ) at a nightclub, a home party, or the like.

Such a CD player stores in a memory an audio signal reproduced from a CD or the like. This CD player is provided with a jog dial having a form like an analog record, so that the speed and order of reading audio signals stored in the memory are controlled according to the rotating direction and speed of the jog dial. By rotating operation of the jog dial similarly to an analog record, an operator such as a DJ can produce sound effects such as friction sounds similar to those in the case where an analog record player is used.

Further, recently a person can readily obtain not only digital audio contents but also digital video contents, for example, with wide spread use of a Digital Versatile Disc (DVD) following the development of the compression technique. Under such circumstances, has been developed a signal processing apparatus that can perform special reproduce of both digital audio signal and digital video signal by operation similar to that in the above-mentioned CD player (See Japanese Unexamined Patent Application Laid-Open No. 2005-108294). A person who operates an audio signal and a video signal by using such a reproduction apparatus in, particularly, a nightclub or a home party is called a Visual Jockey or Video Jockey (VJ).

Such a reproduction apparatus stores a video signal and an audio signal in respective buffer memories, and can asynchronously adjust a reproduction speed of at least one of the signals. By using selection buttons, an operator determines which of the video signal and the audio signal should be adjusted in its reproduction speed or the like.

Document US 2005/185923 A1 discloses a video/audio playback apparatus and a video/audio playback method in which on receiving an instruction for switching video operation from the video operation switching circuit, a data reading circuit reads a video/audio stream for playing an audio and a video/audio stream for playing a video from a recording medium, and an audio playback circuit reproduces an audio stream separated from the video/audio stream for playing the audio on the basis of time management information embedded in the audio stream.

Document EP 1 119194 A2 discloses an audio and video reproduction apparatus for performing variable speed reproduction.

### Disclosure of the Invention

Asynchronous reproduction of a video signal and an audio signal means that reproduction positions of those signals are made to be different from each other. For example, in the case where scratch reproduction is performed only with respect to the video signal while the audio signal is reproduced ordinarily, the reproduction of the video signal is retarded or expedited in comparison with the reproduction of the audio signal according to the time code. In other words, for the audio signal, a current reproduction point of data stored in buffer memories is a time point conforming to the time code, while a current reproduction point for the video signal is different from that time point.

For a VJ for example, it is favorable that a reproduction position of each signal can be varied largely, since the degree of freedom of staging becomes higher.

However, it requires high-capacity buffer memories, a high-speed read drive and the like to ensure large variability of reproduction position of each signal. Further, to realize instantaneous transition from asynchronous reproduction to synchronous reproduction, the buffer memory for one signal must store not only the reproduction position of the signal in question but also data preceding and following the reproduction position of the other signal, requiring a high capacity of buffer memory. Thus, to realize complete freedom of asynchronous reproduction, a reproduction apparatus costs very much.

Considering the above situation, an object of the present invention is to provide a reproduction apparatus, a reproduction method, a program, and a storage medium that enable low-cost asynchronous reproduction of audio and video signals while ensuring free rendering by an operator to the largest extent possible.

A first aspect of the present invention provides a reproduction apparatus as set out in claim 1.

A control part may make the current reproduction points of the audio and video signals coincide with each other after an elapse of the prescribed time for the warning.

A second aspect of the present invention provides a reproduction method as set out in claim 4.

The above method may further comprise a step, in which the current reproduction points of the audio and video signals are made to coincide with each other after an elapse of the prescribed time for the warning.

A third aspect of the present invention provides a computer-readable storage medium as set out in claim 6.

The above program may further comprise a procedure, in which the current reproduction points of the audio and video signals are made to coincide with each other after an elapse of the prescribed time for the warning.

### Brief Description of Drawings

Fig. 1 is a block diagram showing a configuration of a reproduction apparatus according to an embodiment of the present invention;
Fig. 2 is a diagram showing states of buffer memories in an embodiment of the present invention;
Fig. 3 is a flowchart showing operation of a reproduction apparatus according to an embodiment of the present invention; and
Fig. 4 is a diagram showing a state of buffer memories in another embodiment of the present invention.

### Best Mode for Carrying Out the Invention

Now, an embodiment of the present invention will be described in detail referring to the drawings. The embodiment shown in the following is only an example, and does not intend to restrict the present invention.

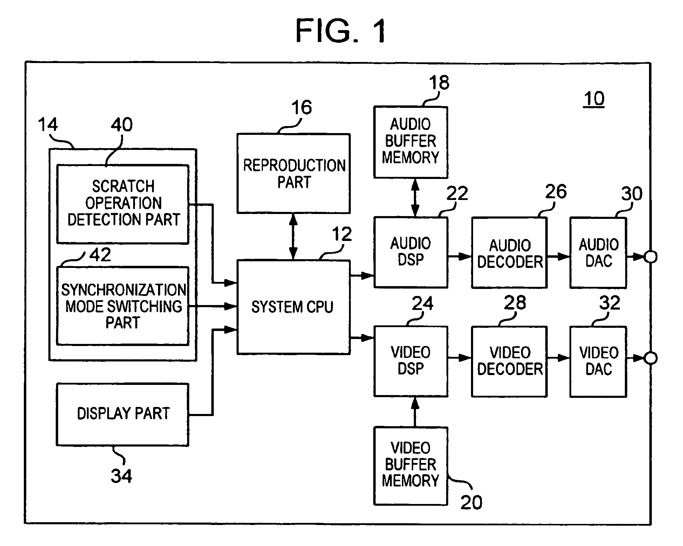

Fig. 1 shows a configuration of an output apparatus of an embodiment of the present invention. A reproduction apparatus 10 shown in Fig. 1 comprises a system Central Processing Unit (CPU) 12, an operation part 14, a reproduction part 16, an audio buffer memory 18, a video buffer memory 20, an audio Digital Signal Processor (DSP) 22, a video DSP 24, an audio decoder 26, a video decoder 28, an audio Digital-to-Analog Converter (DAC) 30, a video DAC 32, and a display part 34.

The system CPU 12 controls the below-described operation of the reproduction apparatus 10 generally.

The reproduction part 16 includes a read drive for a storage medium, and reads and reproduces digital data stored in a storage medium such as a CD, a DVD or the like. The reproduction part 16 may reproduce digital data sent from an external storage unit/reproduction unit, or analog data converted to digital data. An audio signal and a video signal outputted from the reproduction part 16 are components of a same content, and related to each other by a same time code.

The audio buffer memory 18 stores a digital audio signal separated from a composite data stream outputted from the reproduction part 16.

The video buffer memory 20 stores a digital video signal separated from a composite data stream outputted from the reproduction part 16.

The audio buffer memory 18 and the video buffer memory 20 are each formed for example as a ring buffer, which is arranged such that the top memory address is connected with the bottom memory address. In the present embodiment, the audio buffer memory 18 and the video buffer memory 20 have capacities that can store an audio signal and a video signal of the same time length (for example, 30 seconds) respectively.

The audio DSP 22 manages a memory address of the audio buffer memory 18. Further, the audio DSP 22 reads out an audio signal stored in the audio buffer memory 18, in address order and at a speed both designated by the system CPU 12.

The video DSP 24 manages a memory address of the video buffer memory 20. Further, the video DSP 24 reads out a video signal stored in the video buffer memory 20, in address order and at a speed both designated by the system CPU 12. For example, the video DSP 24 performs reproduction frame by frame at the time of high speed reproduction, and a same frame repeatedly at the time of low speed reproduction.

The audio decoder 26 decodes a digital audio signal read by the audio DSP 22 from the audio buffer memory 18.

The video decoder 28 decodes a digital video signal read by the video DSP 24 from the video buffer memory 20.

The audio DAC 30 converts the decoded digital audio signal into an analog audio signal, and outputs the analog audio signal to an external device such as a speaker, a mixer, or the like. If the external device can receive a digital input, output may be given in a prescribed digital format.

The video DAC 32 converts the decoded digital video signal into an analog video signal, and outputs the analog video signal to a monitor, a mixer or the like. If the external device can receive a digital input, output may be given in a prescribed digital format.

The display part 34 comprises a liquid crystal display or the like, and displays an image, attribute information, a reproduction state and the like of data under reproduction.

The operation part 14 has a reproduction start button, a reproduction stop button and the like, and receives operator's input concerning reproduction operation or the like.

Further, the operation part 14 comprises a scratch operation detection part 40 and a synchronization mode switching part 42.

The scratch operation detection part 40 detects operation input by the operator concerning reproduction speed and reproducing order of audio signals and/or video signals. In the present embodiment, operation of reproducing these audio signals or video signals by changing reproduction speed and reproducing order is generically called "scratch operation". "Scratch operation" includes all operations in a state (the below-described scratch mode) that allows reproduction in different order and at different speed from ordinary reproduction.

The scratch operation detection part 40 comprises, for example, an operation disk (not shown) provided with a plurality of slits arranged at nearly regular intervals in the outer peripheral portion and an optical sensor (not shown) having a pair of a light emitting element and a light receiving element. The operation disk is formed similarly to an analog record, and mounted on a turntable (not shown) so that it is rotated at a prescribed reproduction speed such as the reproduction speed of an analog record. Based on pulse signals generated by the optical sensor when light between the light emitting element and the light receiving element passes through slits, the system CPU 12 discriminates a rotation state (rotating speed and direction) of the operation disk to detect a state of scratch operation by the operator. The scratch operation detection part 40 may comprise a rotary encoder and the like to detect rotating operation and the like.

Based on input detected by the scratch operation detection part 40, the system CPU 12 controls the audio DSP 22 and/or the video DSP 24 in reading of an audio signal and/or a video signal from the audio buffer memory 18 and the video buffer memory 20. By this arrangement, the operator can perform scratch reproduction similar to the case using an analog record, by rotating operation of the disk part.

The synchronization mode switching part 42 receives an instruction to switch modes between a synchronous scratch mode, an audio-only scratch mode and a video-only scratch mode.

When the synchronous scratch mode is selected, an audio signal and a video signal are reproduced synchronously according to operation detected by the scratch operation detection part 40.

When the video-only scratch mode or the audio-only scratch mode is selected, an audio signal and a video signal are reproduced asynchronously. That is to say, one of an audio signal and a video signal is reproduced according to operation detected by the scratch operation detection part 40, and the other is reproduced ordinarily in the order according to the time code and at predetermined Beat Per Minute (BPM).

When the scratch operation detection part 40 does not detect scratch operation at the time of asynchronous reproduction, reproduction is performed according to the speed and order that are set in conformity with the time code.

In the following, will be described adjustment of current reproduction points of an audio signal and a video signal in the course of asynchronous reproduction of the present embodiment. Here, "current reproduction point" means a time point (in the time code) at which reproduction (reading) is actually performed in the audio buffer memory 18 or the video buffer memory 20. A current reproduction point goes forward, stays, or goes back as reproduction according to operator's reproduction operation proceeds.

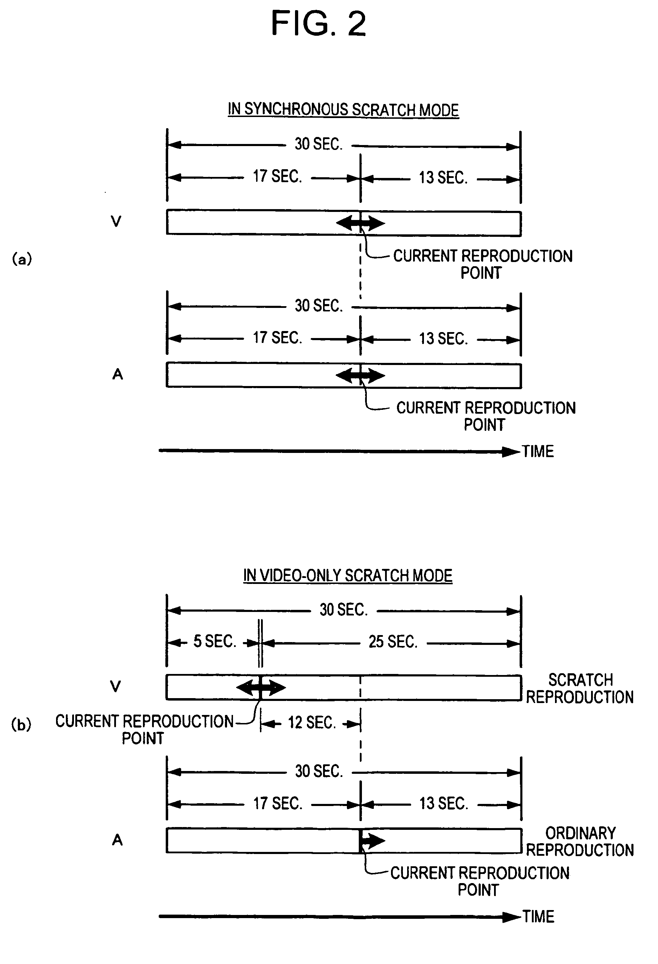

In the present embodiment, as shown in Fig. 2(a), each of the audio buffer memory 18 and the video buffer memory 20 keeps prescribed data quantities for the future and the past with respect to the current reproduction point according to the time code. That is to say, buffer data of the audio buffer memory 18 and the video buffer memory 20 are updated regularly (for example, at intervals of 10 milliseconds) by data of a stream from the reproduction part 16, so as to maintain given quantities of data before and after the current reproduction point. In the example shown in Fig. 2(a), each of the audio buffer memory 18 and the video buffer memory 20 holds data of 30 seconds, i.e. data of 17 seconds for the past from the current reproduction point according to the time code and data of 13 seconds for the future from the current reproduction point.

In the course of reproduction of the synchronous scratch mode, the current reproduction point of the audio signal (A in the figure) and the current reproduction point of the video signal (V in the figure) coincide with each other. Further, not only at the time of ordinary reproduction but also at the time of scratch reproduction, the buffer data are updated as reproduction of both signals proceeds, to secure the prescribed quantities of data for the future and the past. Thus, even when fast-forward reproduction, reverse-reproduction or the like is instructed by scratch operation, it is possible to respond to the instruction because of the buffers of sufficient data quantities.

In the course of the asynchronous reproduction (the audio-only scratch mode or the video-only scratch mode), buffer data of both the audio buffer memory 18 and the video buffer memory 20 are updated as reproduction at the current reproduction point of one signal that is ordinarily reproduced proceeds. For example, in the example shown in Fig. 2(b), the audio signal (A) is reproduced ordinarily in the video-only scratch mode, while the scratch reproduction is performed with respect to the video signal (V). Thus, as for the audio signal in the example shown in the figure, the prescribed quantities of data before and after the current reproduction point are always kept.

On the other hand, as for the signal reproduced by the scratch reproduction (i.e. the video signal V in the example shown in Fig. 2(b)), the buffer data is updated as the reproduction of the other signal (the audio signal) proceeds. As a result, it is possible that the current reproduction point of the signal under scratch reproduction is largely different from the current reproduction point of the other signal. In that case, it is possible that sufficient data are not secured before or after the current reproduction point of the signal under scratch reproduction. For example, in the case where the current reproduction point of the video signal is delayed for 10 seconds from the current reproduction point of the audio signal as shown in Fig. 2(b), data of only 5 seconds are kept before the current reproduction point (i.e. in the direction of reverse reproduction) of the video signal. Thus, in the case where the current scratch reproduction (i.e. the reverse reproduction) is continued, it is probable that the signal under scratch reproduction can not be reproduced owing to a shortage of the buffer data.

In the present embodiment, to avoid such a situation, the system CPU 12 monitors the difference between the current reproduction points of the audio signal and the video signal in the course of reproduction. In the course of asynchronous reproduction, the system CPU 12 monitors the difference between the current reproduction point of the signal under scratch reproduction and the current reproduction point of the other signal under ordinary reproduction, for example on the basis of the time code. The system CPU 12 monitors whether the difference between the respective current reproduction points of the signals becomes more than or equal to a prescribed threshold, for example 10 seconds.

Here, favorably, the threshold of the difference between the current reproduction points of the audio and video signals is set on the basis of the capacities of the audio buffer memory 18 and the video buffer memory 20. In the case where the buffer memories of larger capacities are used, it is possible to secure larger threshold of the difference between the current reproduction points of those signals. However, the larger the capacity is, the higher the price of a memory is. Thus, the capacity of a usable buffer memory is restricted by cost.

When the monitored difference between the current reproduction points becomes more than or equal to the prescribed threshold, the system CPU 12 makes the display part 34 display a warning to that effect. This warning display is given as a text display or a blink/color change of a screen, for example. By the warning, the operator knows that the current reproduction points of the video and audio signals are largely apart from each other and thus the buffer capacity for one signal may become deficient in the reproduction direction or the reverse direction. The warning is displayed for a prescribed time period (for example, for 4 seconds) so that the operator can become aware of and cope with the warning. The warning display is given for example as "Warning ->". Thus, the warning message is displayed together with indication of the regular or reverse direction in which the operator should reproduce (or should not reproduce) the signal under scratch reproduction.

When the warning is displayed, the operator makes operation such that the current reproduction points of the audio and video signals become close to each other in accordance with the currently-performed staging of reproduction. For example, in the example shown in Fig. 2(b), the operator performs forward reproduction (fast-forward reproduction) of the video signal at a speed higher than the reproduction speed of the audio signal in a suitable manner for the currently-performed staging, to reduce the difference between the current reproduction points of the signals. If it is suitable for the staging, the synchronization mode switching part 42 may be operated to switch the mode from the asynchronous reproduction (the video-only scratch mode) to the synchronous reproduction (the synchronous scratch mode).

The system CPU 12 judges whether the difference between the current reproduction points of the video signal and the audio signal is still more than or equal to the prescribed value after a prescribed time period from the warning display. When it is judged that the difference between the current reproduction periods of both signals is more than or equal to the prescribed value after an elapse of the prescribed time, the system CPU 12 makes the current reproduction point of the signal under scratch reproduction coincide (i.e. be synchronized) with the current reproduction point of the other signal under ordinary reproduction. In other words, in the example shown in Fig. 2(b), the state shown in the figure is made to transition to the state shown in Fig. 2(a).

Thus, in the present embodiment, in the case where the difference between the current reproduction points of both signals is more than or equal to the prescribed value after an elapse of the prescribed time while the operator does not notice the warning display or leaves the warning display as it is, the signal under scratch reproduction is forcedly synchronized with the other signal under ordinary reproduction. As for the signal under ordinary reproduction, sufficient data buffer capacities are secured before and after the current reproduction point. Thus, when the difference between the current reproduction points becomes larger and it is possible that the buffer quantity of the signal under scratch reproduction becomes deficient, then the buffer quantity of the signal under scratch reproduction can be sufficiently secured by forcedly synchronizing the signal under scratch reproduction with the signal under ordinary reproduction.

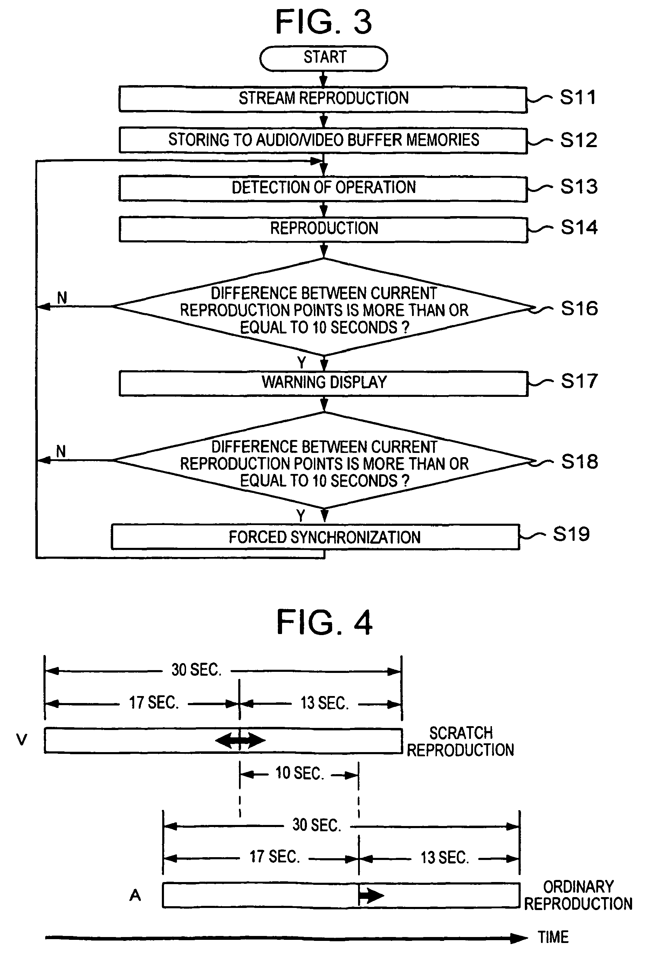

In the following, operation of the reproduction apparatus of the present embodiment in the course of reproduction will be described. Fig. 3 is a flowchart showing reproduction operation. The flowchart shown in the figure is an example. Any flow may be employed as far as a similar result can be obtained.

In the course of the reproduction operation, the system CPU 12 controls the reproduction part 16 to reproduce a composite stream of the audio and video signals (Step S11).

The system CPU 12 controls the audio DSP 22 and the video DSP 24 to separate the audio signal and the video signal in the stream and to store the audio signal and the video signal in the audio buffer memory 18 and the video buffer memory 20 respectively (Step S12). Here, the audio signal and the video signal extracted from the stream are respective pieces of data corresponding to the same time code.

Based on the detected signal from the scratch detection part 40, the system CPU 12 judges the sate of scratch operation (Step S13). When scratch operation is detected, the audio signal and the video signal are read from the audio buffer memory 18 and the video buffer memory 20 at the designated speeds and in the designated orders. As for the video signal, frame processing is performed according to the reproduction speed.

In the synchronous scratch mode, the audio signal and the video signal are read synchronously. In the video-only scratch mode, only the video signal is subjected to the scratch reproduction, while the audio signal is ordinarily reproduced. In the audio-only scratch mode, only the audio signal is subjected to the scratch reproduction, while the video signal is ordinarily reproduced. When scratch operation is not detected, the audio signal and the video signal are read at the ordinary speed and reproduced (Step S14).

In the course of reproduction, the system CPU 12 monitors whether the difference between the current reproduction points for the audio buffer memory 18 and the video buffer memory 20 is more than or equal to the prescribed value, for example 10 seconds (Step S16).

When the difference between the current reproduction points is less than the prescribed value (Step S16: NO), reproduction is performed according to operation by the operator (Step S13). In other words, in this state, within the limited buffer capacities, buffer data of both the audio and video signals are secured sufficiently for enabling scratch reproduction conforming to the intention of the operator.

When the difference between the current reproduction points is more than or equal to the prescribed value (Step S16: YES), the system CPU 12 displays the warning to that effect and the recommended reproduction direction (the regular direction or the reverse direction) for a prescribed time, for example 4 seconds (Step S17). When the operator sees the warning display, the operator knows that the buffer quantity for the signal under scratch reproduction may become deficient and it is better to perform scratch reproduction in the regular or reverse direction. At that time, the operator performs scratch reproduction for eliminating the difference between the current reproduction points of the audio and video signals, as an extension of the currently-performed staging.

For example, in the case where the warning display includes a right arrow "->", the operator knows that the signal under scratch reproduction is backward too much to the reverse direction from the signal under ordinary reproduction, and performs scratch reproduction toward the regular direction. In the case where the operator considers it suitable for desired staging, the operator may switch the mode to the synchronous scratch mode, to make the current reproduction points of the audio and video signals coincide with each other at once.

The system CPU 12 judges whether the difference between the current reproduction points of the audio and video signals is more than or equal to the prescribed value after an elapse of the prescribed time, for example 4 seconds, from the start of the warning display (Step S18). When the difference between the current reproduction points is less than the prescribed value owing to operator's operation (Step S18: NO), the system CPU 12 continues the asynchronous reproduction conforming to operation by the operator (Step S13).

When the difference between the current reproduction points is more than or equal to the prescribed value after the elapse of the prescribed time (Step S18: YES), the system CPU 12 forcedly synchronizes the current reproduction point of the signal under scratch reproduction with the current reproduction point of the other signal under ordinary reproduction (Step S19). After the forced synchronization, the asynchronous reproduction according to operation by the operator is repeated again (Step S13).

That is to say, if the operator leaves the state as it is even after the display of the warning, the current reproduction point of the signal under scratch reproduction is forcedly made to coincide with the current reproduction point of the signal under ordinary reproduction. As a result, in the case where the difference between the current reproduction points of the audio and video signals is larger and the reproduction of the signal under scratch reproduction may be restricted in accordance with the buffer memory capacity, it is possible to avoid deficiency of the buffer quantity certainly.

Since this forced synchronization is performed after an elapse of the prescribed time from the warning display to the operator, the operator has time to eliminate the difference between the current reproduction points, in conformity with the currently-performed staging. Forced synchronization is performed only when the difference between the current reproduction points has not been eliminated after an elapse of the prescribed time. When forced synchronization is performed, listeners of the staging feel it as a part of the staging by the operator. Thus, according to the present embodiment, the operator can perform the freest reproduction staging in asynchronous reproduction of the audio signal and the video signal within the limit of the buffer memories.

As described above, in the present embodiment, difference between the current reproduction points of the audio and video signals is monitored in the course of asynchronous reproduction of the audio and video signals. And, when the difference becomes more than or equal to the prescribed value set in conformity with the limit of the buffer memory capacities, warning is displayed to the operator. Further, when this state is not eliminated after an elapse of the prescribed time, the current reproduction time of the signal under scratch reproduction is forcedly synchronized with the current reproduction point of the signal under ordinary reproduction. Owing to this arrangement, the operator who receives the warning can eliminate the difference between the current reproduction points in conformity with the currently-performed staging. Even when the state is leaved as it is, the current reproduction points of both signals are forcedly synchronized with each other after an elapse of the prescribed time from the display of the warning, and thus the difference between the reproduction points is eliminated certainly. As a result, within the limited buffer memory capacities, the operator has the maximum freedom to perform asynchronous reproduction of the audio signal and the video signal.

The above embodiment has been described assuming that the audio buffer memory 18 and the video buffer memory 20 store an audio signal and a video signal that are extracted from a composite data stream from the reproduction part 16 and correspond to the same time code. However, the present invention can be applied to an arrangement where the audio buffer memory 18 and the video buffer memory 20 store an audio signal and a video signal that are extracted from a composite data stream from the reproduction part 16 for different ranges of time code respectively.

For example, in the example shown in Fig. 4, an audio signal and a video signal are buffered in the audio buffer memory 18 and the video buffer memory 20 by data quantities corresponding to a prescribed time period before and after the current reproduction points of those signals, respectively. As for the video signal, the buffer data are updated in conformity with ordinary reproduction, while, as for the audio signal, the buffer data are updated in conformity with scratch reproduction.

Ideally, in this arrangement, the audio signal and the video signal can be reproduced individually for any data range. Actually, however, there are technical and cost restrictions such as memory capacities. In the example shown in Fig. 4, if the asynchronous mode is switched to the synchronous mode and the current reproduction points of those signals coincide with each other when the difference between the current reproduction points of the audio and video signals exceeds 13 seconds, data corresponding to the current reproduction point of one signal has not been buffered. Thus, reading may be stopped for buffering the data in question.

The present invention can be suitably applied to avoid such a situation. That is to say, the above situation can be avoided when the system CPU 12 monitors the difference between the current reproduction points of the audio and video signals and notifies an operator of excess of the difference over a prescribed value at occurrence of such an event. Further, the current reproduction points of those signals are made to coincide after an elapse of a prescribed time from the warning.

Thus, by applying the present invention to an arrangement where data of an audio signal and a video signal are buffered for respective ranges different from each other, the audio signal and the video signal can be reproduced asynchronously at practically lower cost while ensuring the maximum freedom of staging by an operator.

Further, the above embodiment assumes that one signal is forcedly synchronized with the other signal when the difference between the current reproduction points of the audio and video signals is more than or equal to the prescribed value after elapse of the prescribed time from display of the warning. However, the difference between the current reproduction points may be reduced by a prescribed magnitude, without eliminating the difference. For example, when in this case the difference between the current reproduction points becomes more than or equal to the prescribed value, for example, 10 seconds in the above example, the current reproduction points of both signals are made to be closer to each other by a previously-determined value, for example, several seconds. This arrangement also can avoid increase of the difference between the current reproduction points.

Further, in the above embodiment, when the difference between the current reproduction points of the audio and video signals becomes more than or equal to the prescribed value, a warning is displayed for the prescribed time and thereafter the signals are reproduced synchronously. However, the signals may be synchronized immediately after the difference between the current reproduction points becomes more than or equal to the prescribed value.

Further, in the above embodiment, when the difference between the current reproduction points of the audio and video signals becomes more than or equal to the prescribed value, the signal under scratch reproduction is synchronized with the signal under ordinary reproduction. However, on the contrary, the signal under ordinary reproduction may be synchronized with the signal under scratch reproduction.

Further, the present invention can be implemented by a program for a computer apparatus, a game apparatus, or the like, such as so-called DJ software, DJ game, or the like. Such a program can be previously recorded in a storage medium (such as a CD-ROM), to be operated on a general-purpose personal computer, a game machine, or the like.

### Industrial Applicability

The present invention can be applied very usefully to a reproduction apparatus that asynchronously reproduces stored audio and video signals.

## Claims

1. A reproduction apparatus (10) comprising:
a reproduction part (16) configured to reproduce a stream of an audio signal and a video signal that are related to each other;
an audio buffer memory (18) configured to store the audio signal reproduced by the reproduction part, so that the stored audio signal is read
from the audio buffer memory (18);
a video buffer memory (20) configured to store the video signal reproduced by the reproduction part (16), so that the stored video signal is read from the video buffer memory;
**characterized in that**:
the reproduction apparatus further comprises an operation detection part (40) configured to, in the course of asynchronous reproduction, detect an input operation by an operator concerning read of either of the audio signal and the video signal from the respective buffer memory (18, 20);
the reproduction apparatus further comprises a control part (12) configured to, in the course of asynchronous reproduction, perform control such that one of either of the audio signal and the video signal is read at a certain speed and in certain order from the respective buffer memory (18, 20) and the other signal is read at a speed and in order both corresponding to the input operation detected by the operation detection part, while the control part monitors whether a difference between respective current reproduction points of the audio and video signals becomes more than or equal to a prescribed value; and
if, in the course of asynchronous reproduction, the difference between the current reproduction points becomes more than or equal to the prescribed value, the control part is configured to make a display part (34) display a warning to that effect to the operator for a prescribed time, wherein the warning is displayed together with an indication of a direction in which an operator should or should not reproduce the signal that is read at a speed and in order corresponding to the input operation detected by the operation detection part so as to guide the operator to make an input operation such that the current reproduction points of the audio and video signals become closer to each other.

2. A reproduction apparatus according to Claim 1, wherein the warning is displayed as a text display or a color change of a screen.

3. A reproduction apparatus according to Claim 1, wherein:
the control part is configured to make the current reproduction points of the audio and video signals coincide with each other after an elapse of the prescribed time for the warning.

4. A reproduction method comprising:
a reproduction step, in which a stream of an audio signal and a video signal that are related to each other is reproduced;
an audio buffering step, in which the audio signal reproduced in the reproduction step is stored in an audio buffer memory (18);
a video buffering step, in which the video signal reproduced in the reproduction step is stored in a video buffer memory (20);
an audio read step, in which the audio signal stored in the audio buffer memory (18) is read;
a video read step, in which the video signal stored in the video buffer memory (20) is read;
**characterized in that**:
the reproduction method further comprises
an operation detection step, in which, in the course of asynchronous reproduction, an input operation by an operator concerning read of either of the audio signal and the video signal from the respective buffer memory (18, 20) is detected;
a control step, in which, in the course of asynchronous reproduction, one of either of the audio signal and the video signal is read at a certain speed and in certain order from the respective buffer memory (18, 20), and the other signal is read at a speed and in order both corresponding to the input operation detected in the operation detection step, and further it is monitored whether a difference between respective current reproduction points of the audio and video signals becomes more than or equal to a prescribed value; and
a step, in which if, in the course of asynchronous reproduction, the difference between the current reproduction points becomes more than or equal to the prescribed value, a warning to that effect is displayed to the operator for a prescribed time by a display part (34), wherein the warning is displayed together with an indication of a direction in which an operator should or should not reproduce the signal that is read at a speed and in order corresponding to the input operation detected by the operation detection part so as to guide the operator to make an input operation such that the current reproduction points of the audio and video signals become closer to each other.

5. A reproduction method according to Claim 4, further comprising:
a step, in which the current reproduction points of the audio and video signals are made to coincide with each other after an elapse of the prescribed time for the warning.

6. A computer-readable storage medium that stores a program for making a computer execute:
a reproduction procedure, in which a stream of an audio signal and a video signal that are related to each other is reproduced;
an audio buffering procedure, in which the audio signal reproduced in the reproduction procedure is stored in an audio buffer memory (18);
a video buffering procedure, in which the video signal reproduced in the reproduction procedure is stored in a video buffer memory (20);
an audio read procedure, in which the audio signal stored in the audio buffer memory (18) is read;
a video read procedure, in which the video signal stored in the video buffer memory (20) is read;
**characterized in that**:
the computer-readable storage medium further comprises:
an operation detection procedure, in which, in the course of asynchronous reproduction, an input operation by an operator concerning read of either of the audio signal and the video signal from the respective buffer memory (18, 20); and
a control procedure, in which, in the course of asynchronous reproduction, one of either of the audio signal and the video signal is read at a certain speed and in certain order from the respective buffer memory (18, 20), and the other signal is read at a speed and in order both corresponding to the input operation detected in the operation detection procedure, and further the control procedure includes a procedure in which it is monitored whether a difference between respective current reproduction points of the audio and video signals becomes more than or equal to a prescribed value; and
a procedure, in which if, in the course of asynchronous reproduction, the difference between the current reproduction points becomes more than or equal to the prescribed value, a warning to that effect is displayed to the operator for a prescribed time by a display part (34), wherein the warning is displayed together with an indication of a direction in which an operator should or should not reproduce the signal that is read at a speed and in order corresponding to the input operation detected by the operation detection part so as to guide the operator to make an input operation such that the current reproduction points of the audio and video signals become closer to each other.

7. A computer-readable storage medium according to Claim 6, further comprising:
a procedure, in which the current reproduction points of the audio and video signals are made to coincide with each other after an elapse of the prescribed time for the warning.

## Patentansprüche

1. Wiedergabevorrichtung (10), umfassend:
einen Wiedergabeteil (16), der konfiguriert ist, um einen Strom eines Audiosignals und eines Videosignals, die miteinander in Zusammenhang stehen, wiederzugeben;
einen Audiopufferspeicher (18), der konfiguriert ist, um das durch den Wiedergabeteil wiedergegebene Audiosignal zu speichern, damit das gespeicherte Audiosignal vom Audiopufferspeicher (18) gelesen wird;
einen Videopufferspeicher (20), der konfiguriert ist, um das durch den Wiedergabeteil (16) wiedergegebene Videosignal zu speichern, damit das gespeicherte Videosignal vom Videopufferspeicher (20) gelesen wird;
**dadurch gekennzeichnet, dass**:
die Wiedergabevorrichtung ferner einen Vorgangsdetektionsteil (40) umfasst, der konfiguriert ist, um im Zuge einer asynchronen Wiedergabe einen Eingabevorgang durch einen Bediener betreffend das Lesen von entweder dem Audiosignal oder dem Videosignal vom jeweiligen Pufferspeicher (18, 20) zu detektieren;
wobei die Wiedergabevorrichtung ferner einen Steuerteil (12) umfasst, der konfiguriert ist, um im Zuge einer asynchronen Wiedergabe eine Steuerung durchzuführen, sodass eines von entweder dem Audiosignal oder dem Videosignal bei einer bestimmten Geschwindigkeit und in einer bestimmten Reihenfolge vom jeweiligen Pufferspeicher (18, 20) gelesen wird und das andere Signal bei einer Geschwindigkeit und in der Reihenfolge gelesen wird, die beide dem vom Vorgangsdetektionsteil detektierten Eingabevorgang entsprechen, während der Steuerteil überwacht, ob ein Unterschied zwischen jeweiligen gegenwärtigen Wiedergabepunkten des Audio- und des Videosignals größer oder gleich als ein vorgeschriebener Wert wird; und
wenn im Zuge einer asynchronen Wiedergabe der Unterschied zwischen den gegenwärtigen Wiedergabepunkten des Audio- und des Videosignals größer oder gleich dem vorgeschriebenen Wert wird, der Steuerteil konfiguriert ist, um einen Anzeigeteil (34) dazu zu bringen, dem Bediener eine vorgeschriebene Zeit lang eine diesbezügliche Warnung anzuzeigen, worin die Warnung gemeinsam mit der Angabe einer Richtung angezeigt wird, in der ein Bediener das in einer der dem vom Vorgangsdetektionsteil detektierten Eingabevorgang entsprechenden Geschwindigkeit und Reihenfolge gelesene Signal wiedergeben oder nicht wiedergeben soll, um den Bediener anzuleiten, einen Eingabevorgang vorzunehmen, sodass die gegenwärtigen Wiedergabepunkte des Audio- und des Videosignals sich einander annähern.

2. Wiedergabevorrichtung nach Anspruch 1, worin die Warnung als Textanzeige oder als Farbveränderung eines Bildschirms angezeigt wird.

3. Wiedergabevorrichtung nach Anspruch 1, worin der Steuerteil konfiguriert ist, damit die gegenwärtigen Wiedergabepunkte des Audio- und des Videosignals nach Ablauf der vorgeschriebenen Zeit für die Warnung miteinander übereinstimmen.

4. Wiedergabeverfahren, umfassend:
einen Wiedergabeschritt, in dem ein Strom eines Audiosignals und eines Videosignals, die miteinander in Zusammenhang stehen, wiedergegeben wird;
einen Audiopufferschritt, in dem das im Wiedergabeschritt wiedergegebene Audiosignal in einem Audiopufferspeicher (18) gespeichert wird;
einen Videopufferschritt, in dem das im Wiedergabeschritt wiedergegebene Videosignal in einem Videopufferspeicher (20) gespeichert wird;
**dadurch gekennzeichnet, dass**:
das Wiedergabeverfahren ferner Folgendes umfasst:
einen Vorgangsdetektionsschritt, in dem im Zuge einer asynchronen Wiedergabe ein Eingabevorgang durch einen Bediener betreffend das Lesen von entweder dem Audiosignal oder dem Videosignal vom jeweiligen Pufferspeicher (18, 20) detektiert wird;
einen Steuerschritt, in dem im Zuge einer asynchronen Wiedergabe eines von entweder dem Audiosignal oder dem Videosignal bei einer bestimmten Geschwindigkeit und in einer bestimmten Reihenfolge vom jeweiligen Pufferspeicher (18, 20) gelesen wird und das andere Signal bei einer Geschwindigkeit und in der Reihenfolge gelesen wird, die beide dem vom Vorgangsdetektionsteil detektierten Eingabevorgang entsprechen, und ferner überwacht wird, ob ein Unterschied zwischen jeweiligen gegenwärtigen Wiedergabepunkten des Audio- und des Videosignals größer oder gleich als ein vorgeschriebener Wert wird; und
wenn im Zuge einer asynchronen Wiedergabe der Unterschied zwischen den gegenwärtigen Wiedergabepunkten größer oder gleich dem vorgeschriebenen Wert wird, ein Anzeigeteil (34) dem Bediener eine vorgeschriebene Zeit lang eine diesbezügliche Warnung anzeigt, worin die Warnung gemeinsam mit der Angabe einer Richtung angezeigt wird, in der ein Bediener das in einer der dem vom Vorgangsdetektionsteil detektierten Eingabevorgang entsprechenden Geschwindigkeit und Reihenfolge gelesene Signal wiedergeben oder nicht wiedergeben soll, um den Bediener anzuleiten, einen Eingabevorgang vorzunehmen, sodass die gegenwärtigen Wiedergabepunkte des Audio- und des Videosignals sich einander annähern.

5. Wiedergabeverfahren nach Anspruch 4, ferner umfassend:
einen Schritt, in dem die gegenwärtigen Wiedergabepunkte des Audio- und des Videosignals nach Ablauf der vorgeschriebenen Zeit für die Warnung dazu gebracht werden, miteinander übereinzustimmen.

6. Computer-lesbares Speichermedium, das ein Programm speichert, damit ein Computer Folgendes ausführt:
ein Wiedergabeverfahren, in dem ein Strom eines Audiosignals und eines Videosignals, die miteinander in Zusammenhang stehen, wiedergegeben wird;
ein Audiopufferverfahren, in dem das im Wiedergabeschritt wiedergegebene Audiosignal in einem Audiopufferspeicher (18) gespeichert wird;
ein Videopufferverfahren, in dem das im Wiedergabeschritt wiedergegebene Videosignal in einem Videopufferspeicher (20) gespeichert wird;
ein Audioleseverfahren, in dem das im Audiopufferspeicher (18) gespeicherte Audiosignal gelesen wird;
ein Videoleseverfahren, in dem das im Videopufferspeicher (20) gespeicherte Videosignal gelesen wird;
**dadurch gekennzeichnet, dass** das Computer-lesbare Speichermedium ferner Folgendes umfasst:
ein Vorgangsdetektionsverfahren, in dem im Zuge einer asynchronen Wiedergabe ein Eingabevorgang durch einen Bediener betreffend das Lesen von entweder dem Audiosignal oder dem Videosignal vom jeweiligen Pufferspeicher (18, 20) detektiert wird;
ein Steuerverfahren, in dem im Zuge einer asynchronen Wiedergabe eines von entweder dem Audiosignal oder dem Videosignal bei einer bestimmten Geschwindigkeit und in einer bestimmten Reihenfolge vom jeweiligen Pufferspeicher (18, 20) gelesen wird und das andere Signal bei einer Geschwindigkeit und in der Reihenfolge gelesen wird, die beide dem vom Vorgangsdetektionsteil detektierten Eingabevorgang entsprechen, und ferner überwacht wird, ob ein Unterschied zwischen jeweiligen gegenwärtigen Wiedergabepunkten des Audio- und des Videosignals größer oder gleich als ein vorgeschriebener Wert wird; und
ein Verfahren, in dem, wenn im Zuge einer asynchronen Wiedergabe der Unterschied zwischen den gegenwärtigen Wiedergabepunkten größer oder gleich dem vorgeschriebenen Wert wird, ein Anzeigeteil (34) dem Bediener eine vorgeschriebene Zeit lang eine diesbezügliche Warnung anzeigt, worin die Warnung gemeinsam mit der Angabe einer Richtung angezeigt wird, in der ein Bediener das in einer der dem vom Vorgangsdetektionsteil detektierten Eingabevorgang entsprechenden Geschwindigkeit und Reihenfolge gelesene Signal wiedergeben oder nicht wiedergeben soll, um den Bediener anzuleiten, einen Eingabevorgang vorzunehmen, sodass die gegenwärtigen Wiedergabepunkte des Audio- und des Videosignals sich einander annähern.

7. Computer-lesbares Speichermedium nach Anspruch 6, ferner umfassend:
ein Verfahren, in dem die gegenwärtigen Wiedergabepunkte des Audio- und des Videosignals nach Ablauf der vorgeschriebenen Zeit für die Warnung dazu gebracht werden, miteinander übereinzustimmen.

## Revendications

1. Dispositif de reproduction (10) comprenant :
une partie reproduction (16) conçue pour reproduire un flux d'un signal audio et d'un signal vidéo qui sont liés entre eux ;
une mémoire tampon audio (18) conçue pour stocker le signal audio reproduit par la partie reproduction de sorte que le signal audio stocké soit lu à partir de la mémoire tampon audio (18) ;
une mémoire tampon vidéo (20) conçue pour stocker le signal vidéo reproduit par la partie reproduction (16) de sorte que le signal vidéo stocké soit lu depuis la mémoire tampon vidéo ;
**caractérisé en ce que** :
le dispositif de reproduction comprend en outre une partie détection d'opération (40) conçue pour détecter, au cours d'une reproduction asynchrone, une opération d'entrée effectuée par un opérateur et concernant la lecture de l'un ou l'autre du signal audio ou du signal vidéo à partir de la mémoire tampon respective (18, 20) ;
le dispositif de reproduction comprend en outre une partie commande (12) conçue pour effectuer, au cours d'une reproduction asynchrone, une commande de sorte que l'un ou l'autre du signal audio ou du signal vidéo soit lu à une certaine vitesse et dans un certain ordre à partir de la mémoire tampon respective (18, 20) et que l'autre signal soit lu à une vitesse et dans un ordre correspondant chacun à l'opération d'entrée détectée par la partie détection d'opération, alors que la partie commande surveille si une différence entre les points de reproduction actuels respectifs des signaux audio et vidéo devient supérieure ou égale à une valeur prescrite ; et
si, au cours d'une reproduction asynchrone, la différence entre les points de reproduction actuels devient supérieure ou égale à la valeur prescrite, la partie commande est conçue pour faire afficher par une partie affichage (34) un avertissement à cet effet à l'intention de l'opérateur pendant un délai prescrit, l'avertissement étant affiché conjointement avec une indication du sens dans lequel un opérateur doit ou ne doit pas reproduire le signal qui est lu à une vitesse et dans un ordre correspondant à l'opération d'entrée détectée par la partie détection d'opération de manière à guider l'opérateur pour effectuer une opération d'entrée de sorte que les points de reproduction actuels des signaux audio et vidéo se rapprochent l'un de l'autre.

2. Dispositif de reproduction selon la revendication 1, dans lequel l'avertissement s'affiche sous la forme d'un affichage textuel ou d'un changement de couleur d'un écran.

3. Dispositif de reproduction selon la revendication 1, dans lequel :
la partie commande est conçue pour faire coïncider entre eux les points de reproduction actuels des signaux audio et vidéo une fois que le délai prescrit pour l'avertissement est écoulé.

4. Procédé de reproduction comprenant :
une étape de reproduction lors de laquelle un flux d'un signal audio et d'un signal vidéo qui sont reliés entre eux est reproduit ;
une étape de mise en mémoire tampon audio lors de laquelle le signal audio reproduit à l'étape de reproduction est stocké dans une mémoire tampon audio (18) ;
une étape de mise en mémoire tampon vidéo lors de laquelle le signal vidéo reproduit à l'étape de reproduction est stocké dans une mémoire tampon vidéo (20) ;
une étape de lecture audio lors de laquelle le signal audio stocké dans la mémoire tampon audio (18) est lu ;
une étape de lecture vidéo lors de laquelle le signal vidéo stocké dans la mémoire tampon vidéo (20) est lu ;
**caractérisé en ce que** :
le dispositif de reproduction comprend en outre
une étape de détection d'opération lors de laquelle, au cours d'une reproduction asynchrone, une opération d'entrée effectuée par un opérateur et concernant la lecture de l'un ou l'autre du signal audio ou du signal vidéo à partir de la mémoire tampon respective (18, 20) est détectée ;
une étape de commande lors de laquelle, au cours d'une reproduction asynchrone, l'un ou l'autre du signal audio ou du signal vidéo est lu à une certaine vitesse et dans un certain ordre à partir de la mémoire tampon respective (18, 20), et l'autre signal est lu à une vitesse et dans un ordre correspondant chacun à l'opération d'entrée détectée à l'étape de détection d'opération, et une surveillance est en outre effectuée pour déterminer si la différence entre les points de reproduction actuels respectifs des signaux audio et vidéo devient supérieure ou égale à une valeur prescrite ; et
une étape lors de laquelle si, au cours d'une reproduction asynchrone, la différence entre les points de reproduction actuels devient supérieure ou égale à la valeur prescrite, un avertissement à cet effet est affiché à l'intention de l'opérateur pendant un délai prescrit par une partie affichage (34), l'avertissement étant affiché conjointement avec une indication du sens dans lequel un opérateur doit ou ne doit pas reproduire le signal qui est lu à une vitesse et dans un ordre correspondant à l'opération d'entrée détectée par la partie détection d'opération de manière à guider l'opérateur pour effectuer une opération d'entrée de sorte que les points de reproduction actuels des signaux audio et vidéo se rapprochent l'un de l'autre.

5. Procédé de reproduction selon la revendication 4, comprenant en outre :
une étape lors de laquelle les points de reproduction actuels des signaux audio et vidéo sont amenés à coïncider entre eux une fois que le délai prescrit pour l'avertissement est écoulé.

6. Support de stockage lisible par ordinateur qui stocke un programme destiné à faire exécuter par un ordinateur :
une procédure de reproduction lors de laquelle un flux d'un signal audio et d'un signal vidéo qui sont liés entre eux est reproduit ;
une procédure de mise en mémoire tampon audio lors de laquelle le signal audio reproduit dans la procédure de reproduction est stocké dans une mémoire tampon audio (18) ;
une procédure de mise en mémoire tampon vidéo lors de laquelle le signal vidéo reproduit dans la procédure de reproduction est stocké dans une mémoire tampon vidéo (20) ;
une procédure de lecture audio lors de laquelle le signal audio stocké dans la mémoire tampon audio (18) est lu ;
une procédure de lecture vidéo lors de laquelle le signal vidéo stocké dans la mémoire tampon vidéo (20) est lu ;
**caractérisé en ce que** :
le support de stockage lisible par ordinateur comprend en outre :
une procédure de détection d'opération lors de laquelle, au cours d'une reproduction asynchrone, une opération d'entrée effectuée par un opérateur et concernant la lecture de l'un ou l'autre du signal audio ou du signal vidéo à partir de la mémoire tampon respective (18, 20) est détectée ; et
une procédure de commande lors de laquelle, au cours d'une reproduction asynchrone, l'un ou l'autre du signal audio ou du signal vidéo est lu à une certaine vitesse et dans un certain ordre à partir de la mémoire tampon respective (18, 20), et l'autre signal est lu à une vitesse et dans un ordre correspondant chacun à l'opération d'entrée détectée lors de la procédure de détection d'opération, et la procédure de commande comprend en outre une procédure qui consiste à surveiller si une différence entre les points de reproduction actuels respectifs des signaux audio et vidéo devient supérieure ou égale à une valeur prescrite ; et
une procédure lors de laquelle si, au cours d'une reproduction asynchrone, la différence entre les points de reproduction actuels devient supérieure ou égale à la valeur prescrite, un avertissement à cet effet est affiché à l'intention de l'opérateur pendant un délai prescrit par une partie affichage (34), l'avertissement étant affiché conjointement avec une indication du sens dans lequel un opérateur doit ou ne doit pas reproduire le signal qui est lu à une vitesse et dans un ordre correspondant à l'opération d'entrée détectée par la partie détection d'opération de manière à guider l'opérateur pour effectuer une opération d'entrée de sorte que les points de reproduction actuels des signaux audio et vidéo se rapprochent l'un de l'autre.

7. Support de stockage lisible par ordinateur selon la revendication 6, comprenant en outre :
une procédure lors de laquelle les points de reproduction actuels des signaux audio et vidéo sont amenés à coïncider entre eux une fois que le délai prescrit pour l'avertissement est écoulé.
